# EUROPEAN PATENT SPECIFICATION

(11) **EP 3 666 913 B1**
(45) Date of publication and mention of the grant of the patent: **11.12.2024**
(21) Application number: 19218752.4
(22) Date of filing: 27.06.2018
(51) Int. Cl.: C22C 1/02, C22C 5/04, C22F 1/18, C30B 28/10, C30B 15/08, C30B 29/52, B22D 11/00, B22D 11/117

(54) **METAL MEMBER**
METALLELEMENT
ÉLÉMENT MÉTALLIQUE

(30) Priority: 27.06.2017 JP 2017125222; 29.05.2018 JP 2018102098
(43) Date of publication of application: 17.06.2020
(62) Divisional of application: 18824773.8
(73) Proprietor: C & A Corporation, Sendai-shi, Miyagi 980-8579 (JP); TOHOKU UNIVERSITY, Sendai-shi Miyagi 980-8577 (JP)
(72) Inventor: Yoshikawa, Akira, Sendai-shi, Miyagi 980-8577 (JP); Murakami, Rikito, Sendai-shi, Miyagi 980-8579 (JP); Yokota, Yui, Sendai-shi, Miyagi 980-8577 (JP); Nihei, Takayuki, Sendai-shi, Miyagi 980-8577 (JP); Kamada, Kei, Sendai-shi, Miyagi 980-8577 (JP); Shoji, Yasuhiro, Sendai-shi, Miyagi 980-8579 (JP); Kurosawa, Shunsuke, Sendai-shi, Miyagi 980-8577 (JP); Yamaji, Akihiro, Sendai-shi, Miyagi 980-8577 (JP); Ohashi, Yuji, Sendai-shi, Miyagi 980-8577 (JP)
(74) Representative: Stork Bamberger Patentanwälte PartmbB

(56) References cited:
- EP-A1- 3 124 136
- US-A1- 2017 043 393
- YUUI YOKOTA ET AL: "Fabrication of Metallic Fibers with High Melting Point and Poor Workability by Unidirectional Solidification", ADVANCED ENGINEERING MATERIALS., vol. 20, no. 3, 7 December 2017 (2017-12-07), DE, pages 1700506, XP055682011, ISSN: 1438-1656, DOI: 10.1002/adem.201700506

## Description

### Technical Field

The present invention relates to a metal member made of ruthenium or a ruthenium alloy.

### Background Art

Chemically stable refractory platinum-group elements are used as metal members to be used as electrodes (a central electrode and a ground electrode) of a spark plug, as various sensor electrodes, and in temperature measurement, at high temperatures. Conventionally, platinum and a platinum alloy are used because they have high plastic deformability. On the other hand, as the processing techniques have advanced in recent years, a metal member (to be sometimes referred to as an iridium wire hereinafter) made of iridium or an iridium alloy having a melting point higher than that of platinum is also beginning to be used as a spark plug electrode.

Recently, as the processing techniques have advanced, a metal member (to be sometimes referred to as an iridium wire hereinafter) made of iridium or an iridium alloy having a melting point higher than that of platinum is beginning to be used as a spark plug electrode.

The spark plug electrode is exposed to a high-temperature oxidizing environment in a combustion chamber, so there is a concern about wastage by high-temperature oxidation. Therefore, the spark plug electrode is required to have a high melting point and a high oxidation resistance. Conventionally, a general method of improving the durability of an iridium wire is to properly alloy an additive element such as rhodium, platinum, or nickel in order to adjust the material composition. However, when performing only the improvement based on composition adjustment by alloying, other characteristics deteriorate. This makes it necessary to improve the high-temperature oxidation resistance by a method other than composition adjustment.

As a technique of improving the high-temperature characteristics, approaches based on adjustment of the material structure have also been attempted in addition to adjustment of the composition (constituent elements). For example, patent literature 1 discloses a metal member made of iridium or an iridium alloy in which the abundance ratio of crystals having <100> orientation that appears as preferred orientation during processing is intentionally increased by focusing attention on the orientation of metal crystals.

This improvement of the high-temperature characteristics of a metal member performed by controlling the material structure is not regarded as being completed. For example, when iridium wires disclosed in patent literatures 2 and 3 are compared with iridium wires manufactured by the conventional wire processing, a reduction in oxidation waste amount is observed in a high-temperature oxidizing atmosphere, i.e., a certain effect is confirmed. Since, however, demands have arisen for further improving the high-temperature characteristics, an iridium wire having better high-temperature characteristics is being required.

For the spark plug electrode, for example, it is required to prolong the durability life and further improve the durability in accordance with the improvement in engine performance. Similar high-temperature oxidation resistance improvements are required for thermocouple applications as well. In addition, an area as a target of temperature measurement is sometimes installed in a secluded place. Accordingly, it is also important that a metal member is easy to bend, i.e., has so-called ductility.

### Related Art Literature

### Patent Literature

Patent Literature 1: Japanese Patent Laid-Open No. 2012-136733
Patent Literature 2: Japanese Patent Laid-Open No. 2015-190012
Patent Literature 3: International Publication No. 2012/090714
Patent Literature 4: U.S.P. No. 8,979,696

### Disclosure of Invention

EP 3 124 136 A1 relates to a metal wire rod composed of iridium or an iridium alloy, which is used in applications of ignition plug electrodes, sensor electrodes and the like and which is used in a high-temperature atmosphere.

US 2017/043393 A1 relates to a method for producing a platinum group-based alloy, and more particularly, to production of a molten ingot in a method for producing a platinum group-based alloy.

### Problem to be Solved by the Invention

Since platinum and iridium are very expensive, wires and their processed products using platinum and iridium are also expensive, and this is preventing the widespread use of these metal members. At present, therefore, it is required to obtain a metal member having performance equal to or higher than those of platinum, iridium, and an iridium alloy by using low-cost materials.

The present invention has been made to solve the problems as described above, and has as its object to provide a metal member that has performance equal to or higher than those of platinum, iridium, and an iridium alloy and is less expensive than these metals.

### Means of Solution to the Problem

A metal member according to the present invention is defined in claim 1 and is composed of polycrystals of a metal made of an alloy of Ru, wherein an aspect ratio of a crystal grain is 1.5 or more, a plurality of crystal grains are arranged with major axes thereof being pointed in the same direction, and the number of crystal grains in a section in the direction of the major axes of the crystal grains is 120 or less per 1 mm².

In the above metal member, the metal has a Vickers hardness of 200 Hv (inclusive) to 400 Hv (exclusive).

In the above metal member, in the metal made of Ru, the number of crystal grains in the section in the direction of the major axes of the crystal grains is 260 or less per 0.1 mm².

In the above metal member, the alloy of Ru is represented by Ru_{α}M1_{β}M2_{γ}M3_{ζ}, M1 is one of Rh, Pd, Os, Ir, and Pt, M2 is one of Ta, W, and Re, M3 is an element that improves a corrosion resistance by forming a stable compound with Ru, or an element that improves the corrosion resistance by dissolving in ruthenium by solid solution, and 0.5 < α < 1, 0 ≤ β ≤ 0.5, 0 ≤ γ ≤ 0.5, 0 ≤ ζ ≤ 0.5, and 0 < β + γ + ζ ≤ 0.5.

### Effect of the Invention

As explained above, the present invention has the excellent effect that it is possible to provide a metal member that has performance equal to or higher than those of platinum, iridium, and an iridium alloy and is less expensive than these metals.

### Brief Description of Drawings

Fig. 1A is a view showing the arrangement of a manufacturing apparatus used to form samples of a metal member according to Example 1 of the present invention;
Fig. 1B is a view showing the arrangement of a part of the manufacturing apparatus used to form the samples of the metal member according to Example 1 of the present invention;
Fig. 2 is a photograph showing the result of observation performed by a scanning electron microscope on the section of a sample of a metal member formed in Example 1 of the present invention; and
Fig. 3 is a photograph showing the outer experience of a bending test conducted on a metal member formed in Example 1 of the present invention.

### Best Mode for Carrying Out the Invention

Embodiments of the present invention will be explained below with reference to the accompanying drawings.

### [First Embodiment]

The first embodiment of the present invention will be explained below. A metal member according to the first embodiment of the present invention is composed of polycrystals of a metal made of Ru (ruthenium) or an alloy containing ruthenium at a maximum ratio. Also, the aspect ratio of the crystal grains of the polycrystalline metal member is 1.5 or more. In other words, the length of the major axis of the crystal grain is 1.5 times or more the length of its short axis. The metal member according to the present invention is flame-retardant.

Note that the ruthenium alloy is represented by chemical formula Ru_{α}M1_{β}M2_{γ}M3_{ζ} where M1 is Rh, Pd, Os, Ir, or Pt, M2 is Ta, W, or Re, and M3 is an element that improves the corrosion resistance by forming a stable compound with ruthenium, or an element that improves the corrosion resistance by dissolving in ruthenium by solid solution. In this chemical formula, 0.5 < α < 1, 0 ≤ β ≤ 0.5, 0 ≤ γ ≤ 0.5, 0 ≤ ζ ≤ 0.5, and 0 < β + γ + ζ ≤ 0.5.
Note that the stable compound is a compound that stably exists at room temperature. For example, a compound having a melting point of 1,400°C or more is favorable as the metal member of the first embodiment.

A plurality of crystal grains forming the metal member are arranged with their major axes being pointed in the same direction, and the number of crystal grains in a section parallel to the direction of the major axes of the crystal grains is 2 (inclusive) to 120 (inclusive) per 1 mm². This metal member is, e.g., a wire, and the extending direction of the wire is the major axis direction of the crystal grains. The crystal grains of the metal member are, e.g., columnar crystals, and the material structure is preferably such that the columnar crystals form a bundle in an arbitrary section. Also, the amount of equiaxed crystals is preferably small in the material structure. The ratio of equiaxed crystals is limited in order to suppress a decrease in mechanical strength caused by an increase in grain boundary area. Note that there is no limit on the number of crystal grains in the short-axis direction of the crystal grains.

In the present invention as described above, the grain boundary area is regulated by defining the number of crystal grains in a section parallel to the major axis direction of the crystal grains. The grain boundary of a metal member containing ruthenium is the starting point of high-temperature deterioration or damage, so the grain boundary area is regulated in order to limit this. For example, a wire manufactured by a powder metallurgy method necessarily has many crystal grains and many air gaps. Accordingly, a wire made of the metal member according to the present invention has an oxidation resistance higher than that of a wire manufactured by the powder metallurgy method and having the same composition.

It is also important that the Vickers hardness of the metal member of the first embodiment is 200 Hv (inclusive) to 400 Hv (exclusive). This definition of the hardness is related to the residual strain in the metal member. For example, in the manufacture of a ruthenium wire and a ruthenium alloy wire manufactured by combining processing (hot processing and cold processing) and annealing of an ingot obtained by melting and casting, introduction and relaxation (removal) of processing strain alternately occur, and a metal member processed at a high processing rate until it becomes a wire contains a corresponding residual strain. The processing strain acts as the driving force of recrystallization when the wire is heated to a recrystallization temperature or higher, and changes the material structure (a recrystallized structure). The recrystallized structure increases the grain boundary area, and this accelerates high-temperature wastage and breaking.

Accordingly, for a ruthenium wire and a ruthenium alloy wire for which the use temperature is presumably equal to or higher than the recrystallization temperature, it is favorable to reduce the residual strain in order to suppress a structural change at a high temperature, in addition to limiting the number of crystal grains in the initial state (before the use in a high-temperature atmosphere).

According to the examination by the present inventors, a wire (metal member) having a Vickers hardness of 400 Hv or more is in a state in which the residual strain is excessive. When exposed to a high temperature equal to or higher than the recrystallization temperature, therefore, recrystallization increases the grain boundary area, and this may increase the oxidation waste amount. In addition, the metal member softens due to recrystallization, and a combination of the decreases in hardness and strength and the increase in grain boundary area increases the possibility that breaking occurs from the grain boundary as a starting point. On the other hand, it is originally unpreferable to use a ruthenium wire and a ruthenium alloy wire having a Vickers hardness of less than 200 Hv because they do not have strength required at room temperature.

Note that in order to obtain a wire having a limited hardness as described above, it is necessary to perform processing so that a necessary wire diameter is obtained, while limiting the processing conditions so that no strain remains. This manufacturing process will be described later. Note also that "a wire" in the first embodiment means a thin-wire-like metal member having a diameter of 0.1 mm (inclusive) to 3.0 mm (inclusive). In particular, the diameter is desirably 0.2 mm (inclusive) to 0.8 mmm (inclusive) for a thermocouple, and 0.3 mm (inclusive) to 0.8 mm (inclusive) for a spark plug electrode. Furthermore, "a plate" means a metal member having at least two linear regions in a section perpendicular to the longitudinal direction.

As described above, the metal member of the first embodiment is formed such that the number of crystal grains at room temperature is limited and a structural fluctuation by recrystallization hardly occurs even when the metal member is heated to a high temperature. In the metal member of the first embodiment, therefore, the number of crystal grains varies little when the metal member is heated to a recrystallization temperature (the recrystallization temperature is 1,200°C to 1,500°C although it varies due to the composition of the metal member) or higher. In addition, a change in hardness is reduced. More specifically, when the heating conditions are a heating temperature of 1,200°C and a heating time of 20 hours, a hardness change rate "100 [%] - (hardness after heating/altitude before heating)" is 15% or less.

Next, a method of manufacturing the above-described metal member will be explained. The explanation will be made by taking, as an example, a method of manufacturing a wire as a metal member. A wire of the first embodiment requires the limitation on the number of crystal grains and the limitation on the hardness in order to reduce the residual strain. It is not easy to achieve these limitations by the conventional wire manufacturing process. In the conventional wire manufacturing process, an ingot obtained by the powder metallurgy method or melting and casting is formed into a thin line by performing a rolling process (grooved roll rolling process), a drawing process, and the like. In these manufacturing steps, the number of crystal grains cannot be controlled.

Also, during the course of forming a wire from an ingot, the residual strain exists because processing is performed at a very high processing rate. The residual strain can be reduced by performing hot processing. However, a large amount of residual strain exists because the processing is repetitively performed.

On the other hand, as a wire manufacturing process that can achieve both the limitation on the number of crystal grains and the suppression of the residual strain, it is possible to apply a micro-pulling-down method (to be referred to as a µ-PD method hereinafter) as one mode of the single crystal manufacturing process (see patent literature 2). In the µ-PD method, the number of crystal grains in a section in the major axis direction of the crystal grains can be decreased to a small number of about 260 per 0.1 mm². In addition, the µ-PD method can control the number of crystal grains by using, e.g., a pulling-down rate.

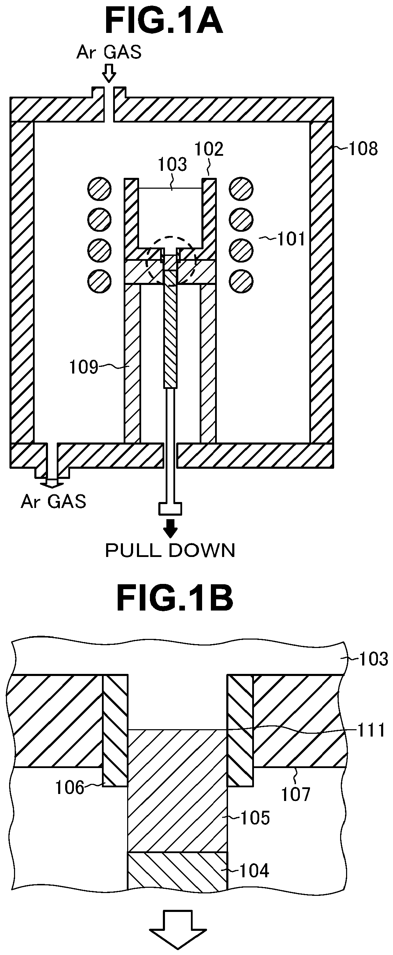

In the µ-PD method as shown in Figs. 1A and 1B, a molten metal 103 as a material is placed in a crucible 102 that can be heated by a radiofrequency induction coil 101, and crystal growth is performed by pulling down a solidified metal (wire) 105 through a nozzle 106 via a growth crystal 104. The nozzle 106 is formed in a bottom 107 of the crucible 102. The crucible 102 is supported and fixed on a crucible table 109 inside a processing chamber 108. Note that Fig. 1B shows a dotted-line circle in Fig. 1A in an enlarged scale.

The µ-PD method is suitably applied to the manufacture of a ruthenium wire and a ruthenium alloy wire because the µ-PD method can manufacture a quasi-monocrystalline metal member having a small number of crystal grains while controlling the shape of crystal grains. Also, the µ-PD method grows crystals while restricting the sectional area to a very small area by the nozzle 106. Therefore, a wire manufactured by this method has a small wire diameter and requires no processing thereafter, or a wire and a plate having desired dimensions can be obtained by a small number of processes. Accordingly, crystals grown by the µ-PD method have little strain and hence require no additional processing. This makes it possible to largely reduce the residual strain, and obtain a low-hardness wire or plate required by the present invention. Thus, manufacturing a metal member such as a wire by using the µ-PD method is an efficient method capable of manufacturing a target metal member by near net shape.

The wire manufacturing method based on the µ-PD method handles a refractory material such as ruthenium or its alloy. Therefore, it is important that the constituent material of the crucible 102 is a material that hardly dissolves nor volatilizes at a high temperature. More specifically, it is possible to use ceramics such as magnesia, zirconia, and alumina, and carbon (graphite). The nozzle 106 formed in the bottom 107 of the crucible 102 has both a function of cooling and solidifying the molten metal that passes through the molten metal 103 from the bottom 107, and a function of restricting and shaping the metal (wire) 105 being solidified as a jig (die). Like the crucible 102, the material of the nozzle 106 is also preferably a material that hardly dissolves nor volatilizes at a high temperature. The inner wall of the nozzle 106 preferably has a smooth surface because friction occurs between the inner wall and the solidified metal.

An important factor when manufacturing a wire having a limited number of crystal grains by the µ-PD method is the position (level) of a solid-liquid interface 111 between the molten metal 103 and the solidified metal (wire) 105. The position of the solid-liquid interface 111 is preferably near the center of the nozzle 106 in the vertical direction. If the position of the solid-liquid interface 111 is on the upper side (the side of the crucible 102), the moving distance of the solidified metal (wire) 105 increases, and the pulling-down resistance increases accordingly. Consequently, abrasion and damage of the nozzle 106 occur, and this makes it difficult to control the shape and dimensions of the wire. On the other hand, if the solid-liquid interface 111 is on the lower side (the exit side of the nozzle 106), the molten metal 103 is discharged from the nozzle 106, and the diameter of the wire may increase. The position of the slid-liquid interface 111 is controlled by properly adjusting the length (thickness) and the pulling-down rate of the nozzle 106. When manufacturing a wire having a wire diameter expected as the metal member of the first embodiment, the length (thickness) of the nozzle 106 is preferably 3 to 30 mm, and the corresponding pulling-down rate is preferably 0.5 to 200 mm/min.

When manufacturing a wire by the µ-PD method, it is also necessary to adjust the cooling rate of the wire 105 discharged from the nozzle 106. The wire 105 discharged from the nozzle 106 is in a solid-phase region, but may form microcrystals (equiaxed crystals) if rapidly cooled. Accordingly, the wire 105 discharged from the nozzle 106 is preferably slowly cooled at a low cooling rate until the temperature becomes lower than the recrystallization temperature. More specifically, the cooling rate is preferably 120°C/sec to 1°C/sec until the temperature of the wire 105 becomes at least 1,200°C or less.

Note that cooling can also be performed at the low cooling rate described above even in a temperature region in which the wire temperature is 1,200°C or less, but the cooling rate can be made higher than the abovementioned rate by taking account of the manufacturing efficiency when the wire temperature is 1,000°C or less. Also, the cooling rate is sometimes adjusted by using the heat of the crucible 102 (the molten metal 103) by, e.g., connecting an after heater made of a heat-conductive material such as ceramics to the lower portion of the crucible 102. The processing of the molten metal 103 in the crucible 102 and the pulling down of the wire 105 are preferably performed in an atmosphere of an inert gas (e.g., nitrogen, argon, or helium) in order to prevent oxidation.

The wire diameters of a ruthenium wire and a ruthenium alloy wire manufactured by the µ-PD method may also be adjusted by additional processing. In this case, however, it is necessary to pay attention to the processing temperature and the processing rate in order to prevent the residual strain. More specifically, it is necessary to set the processing temperature at 1,500°C or more, and set the processing rate at less than 12% for one processing (one pass). If the processing temperature is low or the processing rate is high, strain remains, and the structural changes due to recrystallization occur when the wire is used at a high temperature. A ruthenium wire of the first embodiment manufactured by the µ-PD method explained above can be used as it is properly cut in accordance with an application.

Note that a ruthenium wire of the first embodiment can also be manufactured based on single crystal manufacturing processes, such as a FZ (Floating Zone) method and a zone melting method, other than the µ-PD method. When manufacturing a single crystal having a relatively large diameter, these single crystal growing methods are more suitable than the µ-PD method. However, the FZ (Floating Zone) method and the zone melting method cannot manufacture a continuous wire of φ3 mm or less by near net shape.

Furthermore, when manufacturing a wire having a small diameter of 3 mm or less as a final product by using the FZ method or the like, processing must be performed a plurality of times after the FZ method. When processing is performed a plurality of times, the strain is very likely to remain, and the hardness after the processing becomes Hv 400 or more. Also, if this processed wire is adjusted to less than Hv 400 by annealing or the like, a recrystallized structure containing equiaxed crystals is formed. This extremely deteriorates the mechanical characteristics, particularly the toughness.

### [Example 1]

The present invention will be explained in more detail below by using the results of actually conducted experiments.

First, samples of the metal member of the first embodiment of the present invention will be explained. A wire made of ruthenium or a ruthenium alloy was manufactured based on the µ-PD method by using the manufacturing apparatus explained with reference to Figs. 1A and 1B. When manufacturing a wire by the µ-PD method, the growth crystal 104 is brought into contact with the molten metal 103 in the crucible 102 via the nozzle 106 of the bottom 107. After that, the wire 105 is obtained by pulling down (moving) the growth crystal 104 (downward) at a predetermined rate.

In the manufacture of samples of Example 1, ruthenium and a ruthenium alloy (each of which had a purity of 99% or more) prepared in advance were placed in the crucible 102 made of zirconia (the vessel dimensions were 40 × 30 × 50). In addition, the growth crystal 104 (a φ0.8-mm seed crystal) was inserted from below the nozzle 106 (dimensions: inner diameter = 1mm, length = 5 mm) formed in the bottom 107 of the crucible 102. In this state, the material was melted by radiofrequency induction heating by using the radiofrequency induction coil 101.

After the molten metal 103 of the material was formed in the crucible 102, pulling down was performed at a pulling-down rate of 5 mm/min. In this pulling down, argon gas (1 L/min) was made to flow from the upper portion to the lower portion of the crucible 102. In this example, in a zone of 30 mm from the exit of the nozzle 106, the cooling rate was set at 50°C/sec, and slow cooling was performed until the temperature of the wire 105 became 1,200°C or less. By the manufacturing method described above, the wire 105 having a wire diameter of 0.8 mm and a length of 150 mm was manufactured. Samples 1 to 10 were manufactured as Example 1. Table 1 below shows the compositions of these samples. Table 1 also shows the results of experiments.

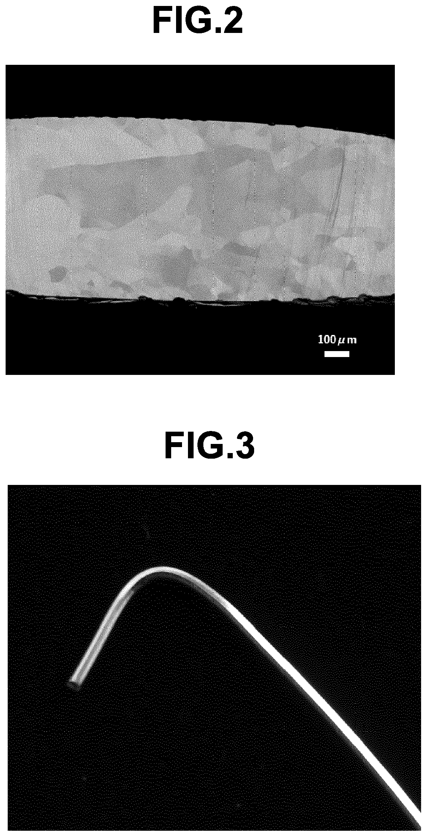

In the experiments, the number of crystal grains and the hardness were first measured by observing the structure of the metal member. In these measurements, the manufactured wire was cut into a length of 1 mm, and the cut wire was further cut in half in the longitudinal direction. Microscopic observation was performed on each sample manufactured as described above, and the number of crystal grains was measured by setting an arbitrary observation field having an area of 0.25 mm². Fig. 2 shows an example (scanning electron microscope photograph) of the observation results. Fig. 2 shows a section parallel to the longitudinal direction of the manufactured wire. That is, a section of the manufactured sample was processed by dry etching (ion milling) using argon gas, and the obtained sample was observed by a scanning electron microscope.

Also, the presence/absence and the number of equiaxed crystals having an aspect ratio of 1.2 or more were measured. In addition, the Vickers hardness of each sample was measured by a Vickers hardness meter. The results of the observation revealed that in each of Samples 1 to 10, the number of crystal grains in the longitudinal-direction section fell within a predetermined range, and the hardness was relatively low.

**[Table 1] Example 1 is a comparative example for reference only**

| | Composition | | | | | | Number of crystal grains | Hardness [Hv] | |
|---|---|---|---|---|---|---|---|---|---|
| | Ru | Rh | Pt | Re | Ni | Al | Before heating | Before heating | 1500 °C |
| Sample 1 | 100 | - | - | - | - | - | 21 | 243 | 226 |
| Sample 2 | 94 | 5 | - | 1 | - | - | 29 | 254 | 232 |
| Sample 3 | 80 | 10 | 10 | - | - | - | 24 | 271 | 250 |
| Sample 4 | 80 | 20 | - | - | - | - | 43 | 293 | 268 |
| Sample 5 | 89 | 10 | - | 1 | - | - | 68 | 231 | 219 |
| Sample 6 | 80 | - | 20 | - | - | - | 55 | 313 | 276 |
| Sample 7 | 89 | 5 | 5 | 1 | - | - | 83 | 301 | 273 |
| Sample 8 | 94 | 2.5 | 2.5 | 1 | - | - | 78 | 340 | 315 |
| Sample 9 | 95 | - | - | - | 5 | - | 29 | 249 | 230 |
| Sample 10 | 87 | 10 | - | - | - | 3 | 24 | 244 | 229 |

Comparative samples will be explained below. The compositions of the comparative samples were the same as those of Samples 1 to 10 in Table 1. Each comparative sample was obtained by manufacturing an ingot (diameter = 12 mm) made of ruthenium and a ruthenium alloy by arc melting, and processing the ingot into a wire through hot processing and heating. In this processing step, the processing was repetitively performed until target dimensions were obtained in each of hot forging, hot wire drawing, and hot swaging. This repetition of hot wire drawing on the comparative samples was performed in order to give the wire a high orientation. However, it was impossible to manufacture the comparative samples because they broke before φ0.8 mm was reached.

Then, high-temperature oxidation heating was performed on each sample, and a structural change and a hardness change after the heating were examined. In addition, a high-temperature oxidation resistance was evaluated by measuring an oxidation waste amount after the heating. Furthermore, the presence/absence of breakage of each sample was evaluated by conducting a bending test on the heated wire. In this bending test, the evaluation was performed by checking breaking of the wire and cracking of the surface when the wire was bent through 90°.

Sufficient high-temperature oxidation resistances were obtained by the wires of Samples 1 to 10. Changes in number of crystal grains before and after the heating were small, and hardness changes were also suppressed. In addition, neither breaking nor surface cracking was found in each sample in the bending test after the heating. Fig. 3 shows the state of Sample 4 after the bending test. As shown in Fig. 3, the wire of Example 1 was bent without breaking, and gloss remained on the surface.

A thermomechanical treatment of a wire and a plate made of ruthenium or a ruthenium alloy will be explained below. In the conventional manufacturing method of performing a thermomechanical treatment on an ingot, grain boundary oxidation caused by a decrease in oxidation resistance and grain boundary cracking during the processing caused by the grain boundary oxidation are problems. By contrast, in the wire manufacturing method using the apparatus shown in Figs. 1A and 1B explained in Example 1, coarse crystal grains are obtained through shape-controlled solidification by near net shape in advance. This makes it possible to obtain a final target shape while suppressing a decrease in yield caused by grain boundary cracking occurring in the thermomechanical treatment.

In this method, crystal grains can be micronized during the processing in a portion influenced by the processing, but these crystal grains can be coarsened to a certain degree by the annealing. Accordingly, a product obtained by the thermomechanical treatment from the wire manufactured by the wire manufacturing method using the apparatus shown in Figs. 1A and 1B explained in Example 1 has a portion where the number of crystal grains is 120 or more per 1 mm². This applies not only to a wire but also to a plate.

In the first embodiment as explained above, a metal member is composed of polycrystals of a metal made of ruthenium or an alloy containing ruthenium at a maximum ratio, the aspect ratio of the crystal grain is 1.5 or more, a plurality of crystal grains are arranged with their major axes being pointed in the same direction, and the number of crystal grains in a section in the direction of the major axes of the crystal grains is 120 or less per 1 mm². Consequently, the first embodiment can provide a material (metal member) having performance equal to or higher than those of platinum, iridium, and an iridium alloy, and less expensive than these metals. For example, the present invention can provide a metal member that has performance equal to or higher than those of platinum, iridium, and an iridium alloy, and is about ten times less expensive than these metals.

Also, from the above results, for a spark plug electrode that is exposed to particularly severe temperature changes and a thermocouple required to have high flexibility when in use, the metal member preferably contains 2 (inclusive) to 80 (inclusive) crystal grains per 1 mm², and preferably has a Vickers Hardness of less than 350 Hv.

For example, a thermocouple is a component using a wire. A thermocouple using ruthenium as an electrode was reported in the past. However, this thermocouple is presently not widely spread because the processability of ruthenium is very low, so an expensive iridium thermocouple is used. Also, since shaping from an ingot is difficult, a high-temperature structure such as a crucible containing ruthenium as a main alloy element is not widely spread, and iridium is used instead. Therefore, if iridium can be replaced with ruthenium, it is greatly expected that price reduction and widespread use advance.

Generally, when using an alloy wire as a spark plug, the wire must be cut into a chip having a thickness of about 1 mm. Shearing is most widely used when cutting a wire into a spark plug, and an existing alloy having high ductility desirably has a structure containing fine crystal grains in order to prevent shear droop during cutting. However, ruthenium and a ruthenium alloy are inferior in ductility to an iridium alloy and a platinum alloy, and hence have the advantage that shear droop hardly occurs during shearing even in a structure containing coarse crystal grains close to a single crystal. Accordingly, processing can be performed without decreasing the oxidation resistance.

The present invention has high novelty and inventive step in that while expensive iridium is replaced with inexpensive ruthenium, the high-temperature oxidation resistance is improved by reducing grain boundaries by increasing the grain size, and a thermomechanical treatment from near net shape is implemented by improving the ductility.

According to the examination by the present inventors, a ruthenium alloy mainly containing ruthenium has a high-temperature resistance and an oxidation resistance equal to those of iridium and an iridium alloy, and it is found that a damage mode in this high-temperature atmosphere often starts from the grain boundary. That is, a metal mainly containing ruthenium preferentially oxidizes (corrodes) in the grain boundaries and wastes in a high-temperature atmosphere. In addition, the metal tends to break from the grain boundaries because a decrease in strength is large in the grain boundaries.

A grain boundary preferential deteriorating mechanism like this is well known for iridium (see patent literature 1). In the iridium wire of patent literature 1, deterioration of the grain boundaries is suppressed by improving the orientation based on the opinion that preferential deterioration of the grain boundaries extends due to the orientation difference between adjacent crystals. On the other hand, regulating the area of the grain boundaries as the original cause of deterioration is a measure that is more essential and most effective. In patent literatures 2 and 3, the oxidation resistance is successfully improved by regulating the area of the grain boundaries in iridium. A similar damage mode is expected in ruthenium as well. Accordingly, it is presumably possible to suppress oxidation (corrosion) in the grain boundaries if the area of the grain boundaries can be regulated in ruthenium.

From the above-described examination, the present inventors considered that it is necessary to examine the presence/absence of a structural change before and after high-temperature heating in order to examine the characteristics of a metal member in a high-temperature atmosphere. In patent literature 1, the structure (orientation) of an iridium wire immediately after the manufacture is defined, but whether the material structure is maintained when exposed to a high temperature is not clarified. In patent literatures 2 and 3, the effect of improving the oxidation resistance is increased by regulating the area of the grain boundaries of iridium.

Improving the oxidation resistance by regulating the area of the grain boundaries has not been examined for ruthenium. This is so because ruthenium is extremely fragile and has low processability, and this makes it impossible to reduce the grain boundaries by increasing the grain size. As a method of manufacturing a ruthenium wire for a spark plug, patent literature 4 discloses a method of forming a clad structure with a highly ductile alloy and repeating hot processing and a heating step a plurality of times.

As mentioned in patent literature 4, a material structure obtained by hot processing like this is fibrous and unavoidably has many grain boundaries. The present inventors have developed a technique of reducing the grain boundaries by increasing the grain size of ruthenium and a ruthenium alloy, and have shown for the first time in the world by taking examples that regulating the area of the grain boundaries is also effective to suppress deterioration (corrosion) of ruthenium and a ruthenium alloy.

From the above examination, the present inventors have found that in order to improve the durability of a ruthenium wire in a high-temperature atmosphere, it is important that the grain boundary area is small, and this small grain boundary area is maintained not only when the wire is manufactured (at room temperature) but also when the wire is exposed to a high temperature, i.e., it is important that a structural change hardly occurs due to heating. As a ruthenium wire like this, the present inventors have made extensive studies including drastic reexamination of the manufacturing method, and have found a suitable ruthenium wire.

The present invention regulates the grain boundary area by defining the number of crystal grains in an arbitrary region in a longitudinal-direction section. As described above, the grain boundary of a metal member containing ruthenium is the starting point of a high-temperature deterioration damage, and the grain boundary area is regulated in order to restrict this. A wire simply manufactured by a powder metallurgy method necessarily has many crystal grains and many air gaps. Accordingly, a wire of the present invention has an oxidation resistance higher than that of a wire manufactured by the powder metallurgy method and having the same composition.

The definition of the hardness is related to the residual strain in the metal member. For example, in the manufacture of a ruthenium wire manufactured by combining processing (hot processing and cold processing) and annealing of an ingot obtained by melting and casting, introduction and relaxation (removal) of processing strain alternately occur, and a metal member processed at a high processing rate until it becomes a wire contains a corresponding residual strain. The processing strain acts as the driving force of recrystallization when the wire is heated to a recrystallization temperature or higher, and changes the material structure (a recrystallized structure). The recrystallized structure increases the grain boundary area, and this accelerates high-temperature wastage and breaking.

Accordingly, for a ruthenium wire for which the use temperature is presumably equal to or higher than the recrystallization temperature, it is favorable to reduce the residual strain in order to suppress a structural change at a high temperature, in addition to limiting the number of crystal grains in the initial state (before the use in a high-temperature atmosphere).

Note that the present invention is not limited to the embodiments explained above, and it is obvious that those skilled in the art can make many modifications and combinations without departing from the invention as defined in the claims.

### Explanation of the Reference Numerals and Signs

101...radiofrequency induction coil, 102...crucible, 103...molten metal, 104...growth crystal, 105...solidified metal (wire), 106...nozzle, 107...bottom, 108...processing chamber, 109...crucible table, 111... solid-liquid interface

## Claims

1. A metal member comprising polycrystals of a metal made of an alloy, **characterized in that** a composition of the alloy is represented by Ru_{α}M1_{β}M2_{γ}M3_{ζ}, wherein
M1 is one of Rh, Pd, Os, and Pt,
M2 is one of Ta, W, and Re,
M3 is an element that improves a corrosion resistance by forming a stable compound with Ru, or an element that improves the corrosion resistance by dissolving in ruthenium by solid solution, **characterized in that**
0.5 < α < 1, 0 ≤ β ≤ 0.5, 0 ≤ γ ≤ 0.5, 0 ≤ ζ ≤ 0.5, and 0 < β + γ + ζ ≤ 0.5,
an aspect ratio of a crystal grain is not less than 1.5, a plurality of crystal grains are arranged with major axes thereof being pointed in the same direction, and
the number of crystal grains in a section in the direction of the major axes of the crystal grains measured by microscopic observation is not more than 120 per 1 mm².

2. The metal member according to claim 1, wherein, the metal has a Vickers hardness of 200 Hv (inclusive) to 400 Hv (exclusive).

## Patentansprüche

1. Metallelement umfassend Polykristalle eines aus einer Legierung hergestellten Metalls, **dadurch gekennzeichnet, dass** eine Zusammensetzung der Legierung durch Ru_{α}M1_{β}M2_{γ}M3_{ζ} wiedergegeben ist, wobei
M1 eines von Rh, Pd, Os und Pt ist,
M2 eines von Ta, W und Re ist,
M3 ein Element ist, das einen Korrosionswiderstand verbessert, indem es eine stabile Verbindung mit Ru bildet, oder ein Element ist, das den Korrosionswiderstand verbessert, indem es sich durch feste Lösung in Ruthenium löst, **dadurch gekennzeichnet, dass**
0,5 < α < 1,0 ≤ β ≤ 0,5, 0 ≤ γ ≤ 0,5, 0 ≤ ζ ≤ 0,5 und 0 < β + γ + ζ ≤ 0,5
ein Aspektverhältnis eines Kristallkorns des Metalls nicht kleiner als 1,5 ist, eine Mehrzahl Metallkörner so angeordnet sind, dass ihre Hauptachsen in die gleiche Richtung zeigen, und
die Anzahl Kristallkörner in einem Abschnitt in Richtung der Hauptachsen der Kristallkörner, gemessen durch Mikroskopbeobachtung, nicht größer als 120 pro 1 mm² ist.

2. Metallelement nach Anspruch 1, wobei das Metall eine Vickers-Härte von 200 Hv (inklusive) bis 400 Hv (exklusive) aufweist.

## Revendications

1. Organe métallique comprenant des polycristaux d'un métal constitué d'un alliage, **caractérisé en ce qu'**une composition de l'alliage est représentée par Ru_{α}M1_{β}M2_{γ}M3_{ζ}, dans lequel
M1 est l'un parmi Rh, Pd, Os et Pt,
M2 est l'un parmi Ta, W et Re,
M3 est un élément qui améliore une résistance à la corrosion par la formation d'un composé stable avec Ru, ou un élément qui améliore la résistance à la corrosion par la dissolution dans le ruthénium par une solution solide, **caractérisé en ce que**
0,5 <α< 1, 0 ≤β≤ 0,5, 0 ≤γ≤ 0,5, 0 ≤ζ≤ 0,5 et 0 <β + γ+ ζ ≤ 0,5,
un rapport d'aspect d'un grain de cristal n'est pas inférieur à 1,5, une pluralité de grains de cristaux sont agencés avec leurs axes majeurs orientés dans la même direction, et
le nombre des grains de cristaux dans une section dans la direction des axes majeurs des grains de cristaux mesuré par observation microscopique n'est pas supérieur à 120 par 1 mm².

2. Organe métallique selon la revendication 1, dans lequel le métal présente une dureté Vickers de 200 Hv (inclus) à 400 Hv (exclu).
